# EUROPEAN PATENT APPLICATION

(11) **EP 4 310 888 A1**
(43) Date of publication of application: **24.01.2024**
(21) Application number: 22186509.0
(22) Date of filing: 22.07.2022
(51) Int. Cl.: H01L 21/04, H01L 21/265, H01L 29/08, H01L 29/10, H01L 29/78, H01L 21/336

(54) **A METHOD OF MANUFACTURING A VERTICAL ORIENTED SEMICONDUCTOR DEVICE AS WELL AS A CORRESPONDING VERTICAL ORIENTED SEMICONDUCTOR DEVICE OBTAINED BY SUCH A METHOD**

(71) Applicant: Nexperia B.V., 6534 AB Nijmegen (NL)
(72) Inventor: Stein, Falk-Ulrich, 22529 Hamburg (DE)
(74) Representative: Pjanovic, Ilija

(57) **Abstract**

A method of manufacturing a vertical oriented semiconductor device, comprising the steps of providing a semiconductor body having a top surface and a current-accommodating region of a first conductivity type, implanting free charge carriers of a second conductivity type, said second conductivity type opposite to said first conductivity type, using a mask on said top surface of said semiconductor body, such that well regions, of the second conductivity type, are provided, said well regions being laterally spaced apart such that the current-accommodating region is provided therein between at a particular depth in said semiconductor material, wherein said implanting is performed under at least two acute angles relative to a surface normal of said top surface such that a W-shaped second conductivity type region is provided in said semiconductor material, etching and/or grinding said semiconductor material from said top surface to said particular depth such that said W-shaped second conductivity region is divided into said well regions having said current-accommodating region therein between.

## Description

### Technical field

The present disclosure is directed to vertical oriented semiconductor devices and, more specifically, to vertical oriented semiconductor devices like transistors or diodes in which well regions are created in a semiconductor body.

### Background

Vertical oriented semiconductor devices are often used for power applications. In such devices, the main current flow is oriented vertically, meaning perpendicular to the semiconductor device surface. In case of a transistor, drain contacts may thus be placed at the bottom side of the vertical oriented transistor. The elementary transistor cells can be placed side by side on a particular chip and can be connected in parallel. This is a common method to achieve a high current component and is therefore especially useful for discrete high current power device.

Conventionally, semiconductor devices were manufactured in silicon-based material. There is however a trend noticeable in which the vertical oriented semiconductor devices are manufactured in silicon carbide based material. Such type of material may provide better performance, especially for high-power and/or high-voltage semiconductor devices.

A Silicon Carbide based semiconductor device may, for example, have multiple advantages over a conventional Silicon based semiconductor device such as a higher critical breakdown field, a higher thermal conductivity and a wider bandgap.

Reducing the cell size of a vertical oriented transistor, for example a Metal Oxide Semiconductor, MOS, Field Effect Transistor, MOSFET, and thereby increasing the channel density per area is one of the main ways to increase the conduction performance of the devices.

This reduction of the cell size is often limited by manufacturing accuracy and required space in between adjacent body implants to avoid a pinch off. To counter the reduction in conduction performance, local doping variations are used especially in the area between the body implants. These doping variations may also impact the parasitic electric properties of the device and thereby also the dynamic device performance.

### Summary

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

It is an object of the present disclosure to provide for a method for manufacturing a vertical semiconductor device. It is a further object of the present disclosure to provide for a corresponding vertical semiconductor device.

In a first aspect, there is provided a method of manufacturing a vertical oriented semiconductor device, comprising the steps of:
- providing a semiconductor body having a top surface and a current-accommodating region of a first conductivity type;
- implanting free charge carriers of a second conductivity type, said second conductivity type opposite to said first conductivity type, using a mask on said top surface of said semiconductor body, such that well regions, of the second conductivity type, are provided, said well regions being laterally spaced apart such that the current-accommodating region is provided therein between at a particular depth in said semiconductor material;
wherein said implanting is performed under at least two acute angles relative to a surface normal of said top surface such that a W-shaped second conductivity type region is provided in said semiconductor material;
- etching said semiconductor material from said top surface to said particular depth such that said W-shaped second conductivity region is divided into said well regions having said current-accommodating region therein between.

The inventors have found that alignment of the implanting process may be important to achieve a constant performance between the different channels. The present disclosure improves the amount of self-aligned implants with reduced mask count as well as an improved dopant profile thereby enabling a higher device performed, as will be elucidated later below.

One of the aspects of the present disclosure is the use of implants under an angle with respect to the surface normal of the top surface to create self-aligned doping profiles in the semiconductor material.

Using subsequent etching and processing, small pitch semiconductor devices may be manufactured with improved doping profiles in the conduction path.

The etching is performed to such a depth that the W-shaped second conductivity region is divided into the well regions. That is, after etching the result is that two separated well regions are provided wherein a current-accommodating region is provided in between those two well regions.

The implanting is performed under at least two acute angles. The first acute angle is mirrored with respect to the surface normal with respect to the second acute angle. For example, the first angle may be 20 degrees and the second angle may be -20 degrees. The two angles are thus mirrored in the vertical axis, wherein the vertical axis coincides with the surface normal of the top surface of the semiconductor material.

In the remainder of the text, the vertical oriented semiconductor device is explained with respect to a vertical oriented Metal Oxide Semiconductor, MOS, Field Effect Transistor, MOSFET. It is however noted that the present disclosure is also directed to vertical diodes, like PN diodes or Schottky diodes.

A MOSFET is typically a type of insulated gate field-effect transistor that is manufactured in a semiconductor material, for example Silicon or Silicon Carbide material. The voltage at a gate terminal determines the electrical conductivity of the device. The ability to change the electrical conductivity may be used for, for example, amplifying or switching particular electronic signals.

In accordance with the present disclosure, the well regions may also be referred to as body implants. Source connections of an opposite conductivity are usually provided in these well regions for providing the source contacts of the MOSFET. The so called current-accommodating region is provided in between the two well regions. The current-accommodating region may be considered the JFET region. The JFET region may, for example, restrict current flow when the depletion widths of the two adjacently placed well region diodes extend into the drift region of the semiconductor device, with increasing drain voltage.

The semiconductor device may comprise a substrate region which is provided at a bottom surface vertically opposite to the top surface, wherein the substrate region is of the first conductivity type. The substrate region may, for example, be connected to a drain contact of the MOSFET. As such, the current will flow vertically between the source contact and the drain contact depending on a voltage applied to the gate contact. The gate contact is explained later below.

In addition to the substrate region, an EPI layer may be provided on top of the substrate region to increase the breakdown voltage of the semiconductor device, for example. The EPI layer may be of the same type of conductivity as the substrate region.

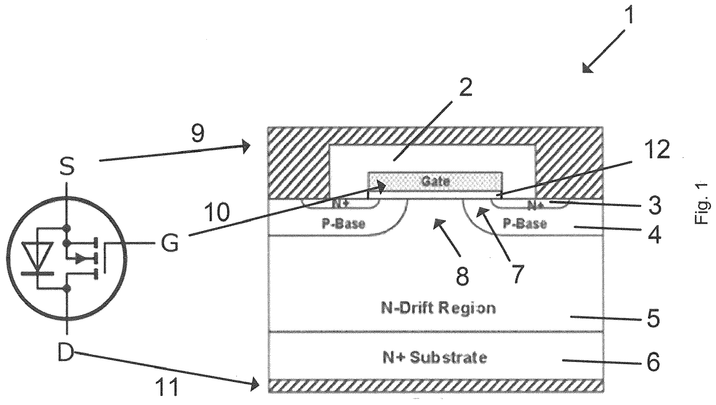

In a typical MOSFET design, a channel will be established between the source contact and the JFET region, i.e. the current accommodating region. The channel is established in a corresponding well region. On top of the channel a dielectric layer may be provided and on top of the oxidation layer a gate contact may be provided. A voltage applied to the gate contact may then influence the free carriers present in the well region such that a channel may be formed. This is explained in more detail with reference to figure 1 later below.

In an example, the method comprises the step of:
- implanting further free charge carriers of the first conductivity type, using the same mask on said top surface of said semiconductor body, wherein said implanting is performed under at least two further acute angles, different from said at least two acute angles, relative to a surface normal of said top surface such that a further W-shaped first conductivity type region is provided in said semiconductor material.

The advantage of the above is that by using the same mask as was used for the initial implanting step, self-alignment of the doping profiles may be achieved. Implanting the further free charge carriers accomplishes that areas of alternating implant concentration are produced which have a different spacing and may have a different depth in the semiconductor material compared to the initial implant.

The step of implanting the further free charge carriers may be directed to generate the source implants of a Metal Oxide Semiconductor, MOS, Field Effect Transistor, FET.

In a further example, a depth of said implanted further free charge carriers in said semiconductor material is different compared to a depth of said implanted free charge carriers in said semiconductor material.

In a further example, the vertical oriented semiconductor device is a Metal Oxide Semiconductor, MOS, Field Effect Transistor, MOSFET, for example, a Silicon Carbide, SiC, MOSFET. That is, the semiconductor material used in the manufacturing process is a Silicon Carbide. Silicon Carbide, SiC, MOSFETs typically exhibit higher blocking voltage, lower on state resistance and higher thermal conductivity than their silicon counterparts making them especially useful for power applications.

In another example, the first conductivity type and said second conductivity type comprises any of N-type and P-type semiconductor material.

In yet another example, the method further comprises any of the steps of:
- growing or depositing gate oxides;
- manufacturing a gate conduction line;
- manufacturing interlayer dielectrics;
- contact etching;
- metal deposition.

In a second aspect of the present disclosure, there is provided a vertical oriented semiconductor device obtained by a method in accordance with any of the examples provided above.

It is noted that the advantages as explained with reference to the first aspect of the present disclosure, being the method of manufacturing a vertical oriented semiconductor device, are also applicable to the second aspect of the present disclosure, being the corresponding vertical oriented semiconductor device.

It is noted that, in accordance with the present disclosure, free charge carriers of the second conductivity type may be implanted multiple times, each using the same mask on the top surface of the semiconductor body, wherein for each implant different acute angles are utilized. The main advantage hereof is that the corresponding well regions, of the second conductivity type, may comprise a doping gradient.

The doping gradient may, for example, have a monotonic decreasing doping concentration from one side of the well region to another side of the well region. This may have multiple advantages over prior art well regions.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

The above and other aspects of the disclosure will be apparent from and elucidated with reference to the examples described hereinafter.

### Brief description of the drawings

Fig. 1 discloses a schematic overview of a vertical semiconductor device being a Metal Oxide Semiconductor, MOS, Field Effect Transistor, MOSFET;
Fig. 2a-c discloses different method steps in manufacturing a vertical semiconductor device in accordance with the present disclosure;
Fig. 3 discloses a schematic overview of a vertical semiconductor device being a MOSFET in accordance with the present disclosure.

### Detailed description

It is noted that in the description of the figures, same reference numerals refer to the same or similar components performing a same or essentially similar function.

A more detailed description is made with reference to particular examples, some of which are illustrated in the appended drawings, such that the manner in which the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or," in reference to a list of two or more items, covers all of the following interpretations of the word: any of the items in the list, all of the items in the list, and any combination of the items in the list.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

Fig. 1 discloses a schematic overview of a vertical semiconductor device being a Metal Oxide Semiconductor, MOS, Field Effect Transistor, MOSFET 1.

At the left hand side of figure 1, a traditional diagram of a MOSFET is shown, wherein the MOSFET comprises a gate terminal 10, a source terminal 9 and a drain terminal 11.

At the right hand side of figure 1, the implementation of the MOSFET 1 in Silicon Carbide is depicted. The same figure may be applicable for an implementation in Silicon. The arrows 9, 10, 11 indicate the respective positions of the source terminal, the gate terminal and the drain terminal in the corresponding Silicon Carbide material.

The MOSFET is a vertical oriented MOSFET in the sense that the current flow vertically, i.e. between the source terminal 9 and the drain terminal 11.

Two well regions are provided in the Silicon Carbide material, one of which is indicated with the reference numeral 4. The well regions are of the P-type conductivity. In the well regions 4, source contacts 3 are provided for connection to the source terminal 9. The source contacts 3 are of the N-type conductivity.

The substrate 6 and the drift region 5 of the semiconductor material is also of the N-type conductivity, wherein the doping concentration of the drift region 5 is usually a bit lower than the doping concentration of the substrate 6.

The present disclosure defines a current-accommodating region which is indicated by the reference numeral 8. In accordance with the present disclosure, the current-accommodating region 8 is situated between the two well regions 4.

The channel 7 is created in the well regions 4 based on the voltage applied to the gate terminal 10. Once the voltage at the gate terminal 10 is sufficiently high, a channel will occur to ensure that free carriers are able to move between the source contact 3 and the drain terminal 11. As such, current will flow between the source terminal 9 and the drain terminal 11.

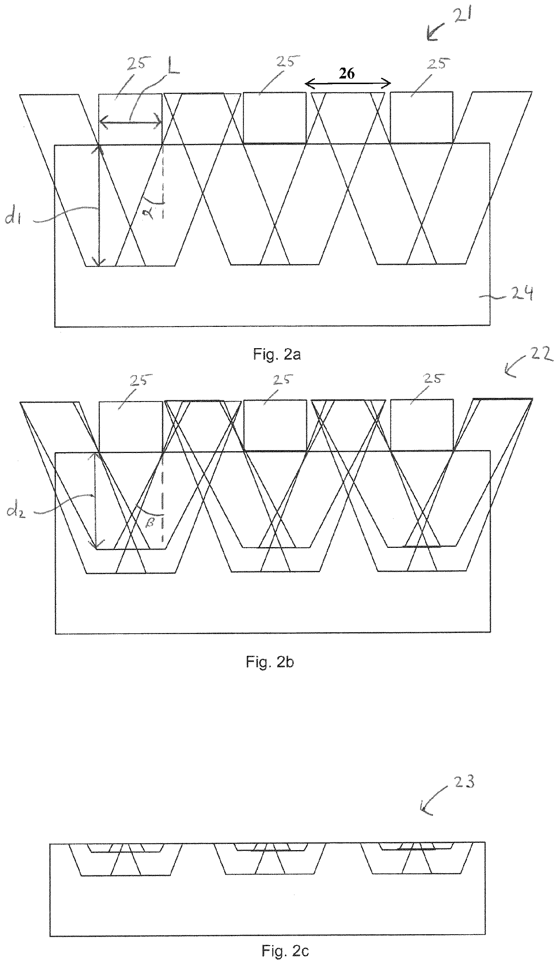

Fig. 2a-c discloses different method steps in manufacturing a vertical semiconductor device in accordance with the present disclosure.

One of the aspect of the present disclosure is shown in figures 2a - 2c, i.e. the use of implants under an angle with respect to the crystal / top surface to create self-aligned doping profiles underneath the crystal surface. With subsequent etching and processing small pitch MOSFETs are manufactured with optimized doping profiles in the conduction path.

Reference is first made to the first method step as indicated with reference numeral 21. The doping structures are manufactured into the semiconductor substrate or the epitaxial layer by implants under various angles with respect to the top surface.

The lateral layout is defined by a structured masking layer on top of the semiconductor material as shown in Fig. 1. The masks are indicated with reference numeral 25.

In order to create an alternating dopant structure as shown for a MOSFET device multiple, consecutive implants with changing implant angles are performed. By choosing the lengths of the masks L in combination with the chosen implant angle *α*, a doping geometrie may be obtained. The cell pitch may further be defined by the spacing between the masks, as indicated with reference numeral 26. The cell picth may nog equal the spacing between the masks, but the cell pitch is a result of the spacing between the masks.

The combination of the mask width L, the space width 26 and the different angles that are used for the implanting process together with the etching depth may all directly impace the created geometry of the particular MOSFET, and thus also the particular cell pitch of the MOSFET.

Fig. 2a shows an example in which the implanting is performed under two acute angles relative to a surface normal of said top surface such that a W-shaped second conductivity type region is provided in said semiconductor material.

Fig. 2b shows an example 22 in which an additional implanting is performed under at least two further acute angles, different from said at least two acute angles, relative to a surface normal of said top surface such that a further W-shaped first conductivity type region is provided in said semiconductor material. This further implant may be performed at a different depth, i.e. d2, compared to the first implant depht, i.e. d1. This implant may form the source regions of the MOSFET.

The implants show a slanted profile as well which can be beneficial in device performance and in case of a MOSFET it enables a smaller cell pitch thus increasing the performance per area.

Using the same mask 25 with a second dopant for implants under an angle *β* produces again areas of alternating implant concentration but with a different spacing and depth d2 compared to the first implant. The overlap between the two implants is hereby self-aligned.

In principle more of these implants could be performed but for a MOSFET structure the two may be sufficient. The present disclosure is also directed to multiple of these implants, each with different implant angles.

Fig. 2c shows an example 23 in which the mask 25 is removed and the semiconductor material is etched and/or grinded down from the top surface until a specific depth that brings the alternating pattern of dopants to the new semiconductor surface.

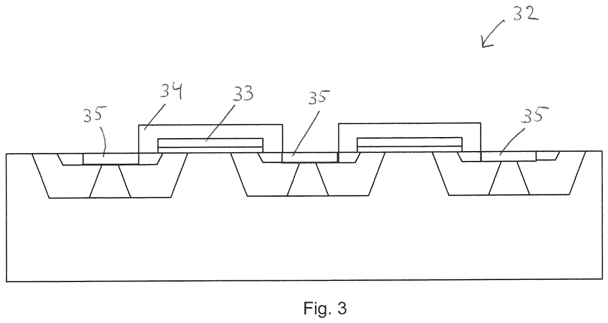

Fig. 3 discloses a schematic overview of a vertical semiconductor device being a MOSFET 32 in accordance with the present disclosure.

Here, the gate polysilicon is indicated with reference numeral 33, the interlayer dielectric is indicated with reference numeral 34 and the source contacts are indicated with reference numeral 35. These are either etches, with ohmic metallization afterwards, deep silicide or other forms of contacting the different regions.

One of the advantages of the present disclosure is directed to the creation of MOSFET device doping geometries for a source, a body as well as a body contact underneath the crystal surface by using only one mask and different angles to make it accessible for further processing by surface removal, wherein a smaller cell pitch is obtained and therefore higher performance.

In the above, the present disclosure is explained with respect to a MOSFET. It is noted that the present disclosure may be applicable for any vertical oriented semiconductor device having at least one junction between semiconductor material of a first type and semiconductor material of a second type. It is further noted that the present disclosure is also applicable for a semiconductor device having no PN junction, but having a transition between a metal part and a semiconductor material like, for example, a Schottky diode.

To reduce the number of claims, certain aspects of the technology are presented below in certain claim forms, but the applicant contemplates the various aspects of the technology in any number of claim forms. For example, while some aspect of the technology may be recited as a computer-readable medium claim, other aspects may likewise be embodied as a computer-readable medium claim, or in other forms, such as being embodied in a means-plus-function claim.

In the description above, for the purposes of explanation, numerous specific details are set forth in order to provide a thorough understanding of implementations of the disclosed technology. It will be apparent, however, to one skilled in the art that embodiments of the disclosed technology may be practiced without some of these specific details.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope thereof.

### LIST OF REFERENCE NUMERALS

- 1: Metal Oxide Semiconductor, MOS, Field Effect Transistor, MOSFET
- 2: Interlayer dielectric
- 3: Source terminal
- 4: Well region
- 5: Drift region
- 6: Substrate
- 7: Channel
- 8: Current-accommodating region
- 9: Source terminal
- 10: Gate terminal
- 11: Drain terminal
- 12: Oxide
- 21: First method step
- 22: Example
- 23: Example
- 24: Substrate
- 25: Mask
- 26: Distance between masks
- 32: MOSFET
- 33: Polysilicon
- 34: Interlayer dielectric
- 35: Source contacts

## Claims

1. A method of manufacturing a vertical oriented semiconductor device, comprising the steps of:
- providing a semiconductor body having a top surface and a current-accommodating region of a first conductivity type;
- implanting free charge carriers of a second conductivity type, said second conductivity type opposite to said first conductivity type, using a mask on said top surface of said semiconductor body, such that well regions, of the second conductivity type, are provided, said well regions being laterally spaced apart such that the current-accommodating region is provided therein between at a particular depth in said semiconductor material;
wherein said implanting is performed under at least two acute angles relative to a surface normal of said top surface such that a W-shaped second conductivity type region is provided in said semiconductor material;
- etching and/or grinding said semiconductor material from said top surface to said particular depth such that said W-shaped second conductivity region is divided into said well regions having said current-accommodating region therein between.

2. A method in accordance with claim 1, wherein said method comprises the step of:
- implanting further free charge carriers of the second conductivity type, using the same mask on said top surface of said semiconductor body, wherein said implanting is performed under at least two further acute angles, different from said at least two acute angles, relative to a surface normal of said top surface such that a further W-shaped first conductivity type region is provided in said semiconductor material.

3. A method in accordance with claim 2, wherein a depth of said implanted further free charge carriers in said semiconductor material is less deep compared to a depth of said implanted free charge carriers in said semiconductor material.

4. A method in accordance with any of the previous claims, wherein said vertical oriented semiconductor device is a Metal Oxide Semiconductor, MOS, Field Effect Transistor, MOSFET.

5. A method in accordance with claim 4, wherein said semiconductor device is a Silicon Carbide, SiC, MOSFET.

6. A method in accordance with any of the previous claims, wherein said first conductivity type and said second conductivity type comprises any of N-type and P-type semiconductor material.

7. A method in accordance with claim 4, wherein said method further comprises any of the steps of:
- growing or depositing gate oxides;
- manufacturing a gate conduction line;
- manufacturing interlayer dielectrics;
- contact etching;
- metal deposition.

8. A vertical oriented semiconductor device obtained by a method in accordance with any of the claims 1 - 7.
